# EUROPEAN PATENT APPLICATION

(11) **EP 1 022 826 A2**
(43) Date of publication of application: **26.07.2000**
(21) Application number: 00100085.0
(22) Date of filing: 05.01.2000
(51) Int. Cl.: H01S 5/227

(54) **Semiconductor laser and method of manufacturing the same**

(30) Priority: 22.01.1999 JP 1474699
(71) Applicant: NEC CORPORATION, Tokyo (JP)
(72) Inventor: Inomoto, Yasumasa, c/o NEC Corporation, Tokyo (JP)
(74) Representative: Glawe, Delfs, Moll & Partner

(57) **Abstract**

In a semiconductor laser, an active layer mesa stripe (103) is formed on a mesa stripe (102) of a semiconductor substrate (101). Current blocking layers (104) are formed on the semiconductor substrate around the mesa stripe on both sides of the active layer mesa stripe. A clad layer (105) is formed on the active layer mesa stripe and the current blocking layers.

## Description

### Background of the Invention

### 1. Field of the Invention

The present invention related to a semiconductor laser and a manufacturing method for the same, and more particularly to a semiconductor laser which is suitable for a high power light output operation and a high temperature operation and a manufacturing method for the same.

### 2. Description of the Related Art

In a semiconductor laser for an optical communication, it is one of important factors to reduce a drive current in case of a high output power operation or an operation at high temperature. Therefore, it is important to realize the structure in which the drive current can be injected into an active layer efficiently. More specifically, the structure called an embedded type is generally used in which current blocking layers of a pnpn thyristor structure are arranged on both sides of the active layer mesa stripe. In a method of manufacturing the embedded type semiconductor laser, an active layer mesa stripe is formed directly on a semiconductor substrate by a selective MOVPE (Metal Organic Vapor Phase Epitaxy) method, and the current blocking layers are formed by a selective growth method. For example, this technique is described in the paper of "Novel MQW-DCPBH LDs fabricated by all selective MOVPE laser diodes (ASM-DVPBH-Lds)" by Sakata et al. (the 1995 fall Applied Physics national conference).

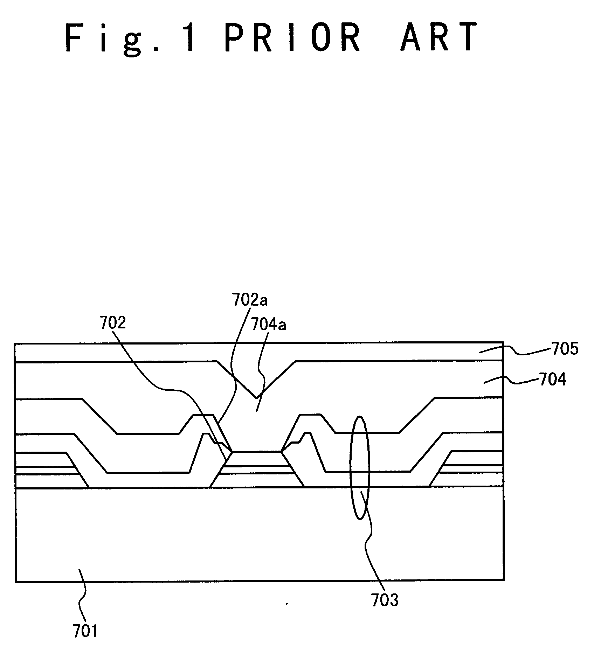

Fig. 1 shows the structure of a conventional semiconductor laser. In this semiconductor laser, active layer mesa stripes 702 are formed directly on an n-InP substrate 701 by the selective growth method and are provided in a predetermined interval. Current blocking layer 703 are provided between the active layer mesa stripes 702. Upper extending sections 702a are formed in the side end portion of the current blocking layer 703. Moreover, a clad layer 704 is formed in an inverse trapezoid shape on the current blocking layer 703 and the active layer mesa stripe 702, and a cap layer 705 is provided on this clad layer 704.

According to this structure, the cross section of the active layer mesa stripe 702 has a predetermined trapezoid shape and is always surrounded by the (100) plane and the (111)B plane. Therefore, the shape of the current blocking layers 703 can be reproducibly well controlled to be formed on the both sides of the active layer mesa stripe 702. As a result, the device characteristic of the current blocking layer 703 is excellent in the uniformity and the reproducibility.

However, according to the conventional example of the semiconductor laser, the current blocking layers 703 extend upward from the active layer mesa stripe 702. This is because it is necessary for the current blocking layer 703 to have the film thickness equal to or more than 1.5 µm for a sufficient current blocking function, when the height of the active layer mesa stripe 702 is 0.5 µm. However, when the current blocking layer 703 is made thick, the resistance of the clad layer 704a directly on the active layer mesa stripe 702 increases.

The resistance of the clad layer 704a influences the temperature increase of the active layer mesa stripe 702. Therefore, in order to attain the semiconductor laser which is suitable for a high temperature operation and a high light output power operation, it is important to prevent the gain of the active layer mesa stripe 702 from being decreased.

In conjunction with the above description, a method of manufacturing a semiconductor laser is disclosed in Japanese Laid Open Patent Application (JP-A-Heisei 3-22582). In this reference, a mask layer is formed on a (100) plane exposed on a compound semiconductor substrate of a conductive type to have an opening in a stripe parallel to a (110) plane. A crystal layer having a double-hetero structure in which an acitve layer is sandwiched at least is selectively grown on the compound semiconductor substrate surface exposed in the opening using a metal organic vapor phase epitaxy (MOVPE) method. Then, the mask layer is removed. A crystal layer is grown on the surface of the compound semiconductor substrate which is exposed by removing the mask layer to embed the crystal layer having the double-hetero structure.

Also, a semiconductor laser is disclosed in Japanese Examined Patent Application (JP-B-Heisei 8-34336). In this reference, a dielectric film is formed on a semiconductor substrate. A groove is formed in the dielectric film to reach the substrate. A laminate structure in a mesa stripe shape is provided on the substrate surface in the groove. Embedding layers are formed on the both side of the laminate structure. The main plain of the substrate is a (100) plane and the groove is formed in a 〈011〉 direction. The laminate structure is a lower portion including an active layer and an upper portion including a semiconductor layer having a smaller refractive index than the active layer. The side of the lower portion is a facet with {111} plane, and the side of the active layer is covered by the semiconductor layer.

Also, a light semiconductor element is disclosed in Japanese Laid Open Patent Application (JP-A-Heisei 9-92935). In this reference, a buffer layer (3) composed of InP or InGaAsP is formed on a semiconductor substrate (1). An intermediate layer (7) composed of InGaAsP is formed on the buffer layer (3). An active layer (4) composed of InGaAs or InGaAsP having a wavelength longer than 1.5 µm is formed on the intermediate layer (7) and further an intermediate layer (8) is formed thereon. Then, a cover layer (5) composed of InP or InGaAsP is formed the intermediate layer (8). Even if all the layers are grown by a MOVPE method, it is possible to prevent replacement of elements between the buffer layer (3) or the cover layer (5) and the active layer (4).

Also, a method of manufacturing a semiconductor device is disclosed in Japanese Laid Open Patent Application (JP-A-Heisei 9-36478). In this reference, a mask (2) is formed on the surface of a semiconductor substrate of n-type InP with (100) plane to have an opening in a stripe shape in a 〈011〉 direction. A semiconductor laser structure is formed in the opening by an MOVPE method. In this case, a concave portion is formed on the InP substrate (1) in the opening. An InP buffer layer (3) is formed in the concave portion to have a film thickness thinner than the depth of the concave portion. Then, an InGaAsP active layer (4) and a p-type InP clad layer (5) are grown on the buffer layer (3).

### Summary of the Invention

Therefore, an object of the present invention is to provide a semiconductor laser which is suitable for a high light output operation and a high temperature operation, and a manufacturing method the same.

In order to achieve an aspect of the present invention, a semiconductor laser includes a semiconductor substrate with a mesa stripe; an active layer mesa stripe formed on the mesa stripe; current blocking layers formed on the semiconductor substrate around the mesa stripe on both sides of the active layer mesa stripe; and a clad layer formed on the active layer mesa stripe and the current blocking layers.

Here, it is preferable that the semiconductor substrate has (100) plane and the mesa stripe extends into 〈011〉 direction. Also, it is preferable that the semiconductor substrate and the mesa stripe composed of the same material and have the same carrier concentration.

The film thickness of the current blocking layer is smaller than (1.5 µm + (a film thickness of the mesa stripe)). In this case, the film thickness of the current blocking layer is in a range 1.5 µm to (1.5 µm + (a film thickness of the mesa stripe)).

The the current blocking layer preferably has a thyristor structure of pnpn.

Also, when the semiconductor substrate and the mesa stripe are both an n-type, the active layer mesa stripe 205 includes: an n-type layer; an n-type light confining layer; a non-doped MQW (Multi-Quantum Well) active layer with 7 periods; and a non-doped light confining layer. Each of the 7 periods of the non-doped MQW active layer 103c has a well with a strain and a barrier layer.

In order to achieve another aspect of the present invention, a method of manufacturing a semiconductor laser is attained by providing a semiconductor substrate with a mesa stripe; forming an active layer mesa stripe on the mesa stripe; forming current blocking layers on the semiconductor substrate around the mesa stripe on both sides of the active layer mesa stripe; and forming a clad layer on the active layer mesa stripe and the current blocking layers.

In the providing, the mesa stripe may be formed on the semiconductor substrate. Alternatively, a portion of the semiconductor substrate forming around the mesa stripe may be removed to produce the mesa stripe.

The semiconductor substrate has (100) plane and the mesa stripe extends into 〈011〉 direction, and the semiconductor substrate and the mesa stripe composed of the same material and have the same carrier concentration.

The film thickness of the current blocking layer is smaller than (1.5 µm + (a film thickness of the mesa stripe)). In this case, the film thickness of the current blocking layer is in a range 1.5 µm to (1.5 µm + (a film thickness of the mesa stripe)).

Also, when the semiconductor substrate and the mesa stripe are both an n-type, the forming an active layer mesa stripe 205 is attained by forming an n-type layer; forming an n-type light confining layer; forming a non-doped MQW (Multi-Quantum Well) active layer with 7 periods, each of which has a well with a strain and a barrier layer; and forming a non-doped light confining layer.

### Brief Description of the Drawings

Fig. 1 is a cross sectional view showing the structure of a conventional semiconductor laser;
Fig. 2 is a cross sectional view showing a semiconductor laser according to a first embodiment of the present invention;
Figs. 3A to 3E are cross sectional views showing a manufacturing process in a manufacturing method of the semiconductor laser according to the first embodiment of the present invention;
Fig. 4 is a cross sectional view showing the semiconductor laser according to a second embodiment of the present invention;
Figs. 5A to 5E are cross sectional views showing a manufacturing process of the semiconductor laser according to the second embodiment of the present invention;
Fig. 6 is a cross sectional view showing the semiconductor laser according to a third embodiment of the present invention; and
Fig. 7 is a cross sectional view showing the semiconductor laser according to a fourth embodiment of the present invention.

### Description of the Preferred Embodiments

Hereinafter, the semiconductor laser of the present invention will be described below in detail with reference to the attached drawings.

### [First embodiment]

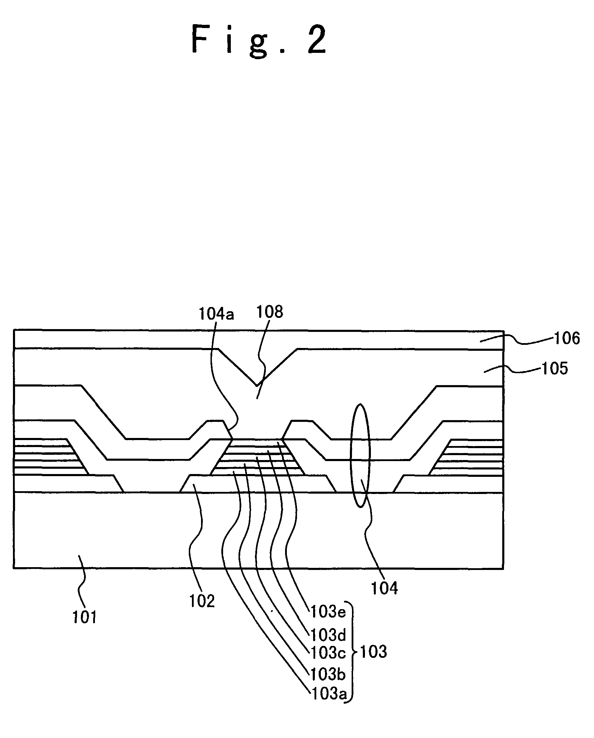

Fig. 2 shows the semiconductor laser according to the first embodiment of the present invention. A buffer layer mesa stripe 102 of n-type InP is formed on an n-InP substrate 101 by a selective MOVPE method. An active layer mesa stripe 103 is provided on the buffer layer mesa stripe 102.

The active layer mesa stripe 103 has the structure in which an n-InP clad layer 103a, an n-InGaP light confining layer 103b, a MQW (Multi-Quantum Well) active layer 103c composed of an InGaAsP well and a barrier layer, a non-doped InGaAsP light confining layer 103d and a P-InP clad layer 103e are laminated in order.

Current blocking layers 104 having the thyristor structure of pnpn-InP, i.e., pnpn in the lower layer and InP in the upper layer are provided for both sides of the active layer mesa stripe 103. The current blocking layers 104 are embedded by the clad layer 105 of p-type InP. Moreover, the cap layer 106 composed of p⁺-type InGaAs is provided onto the clad layer 105.

Electrodes (not shown) are provided on the cap layer 106 and under the n-InP substrate 101 and a drive voltage is applied to the electrodes. A positive voltage is applied to the electrode on the cap layer 106 and a negative voltage is applied to the electrode on under the n-InP substrate 101. At this time, electrons and holes are injected in high concentrations to the stripe portion of the active layer mesa stripe 103. As a result, the electron and the hole recombine in the active layer mesa stripe 103 to generate an induced emission light into the direction orthogonal to the drawing in Fig. 2.

In the present invention, a buffer layer mesa stripe 102 is provided between the n-InP substrate 101 and the active layer mesa stripe 103. Thus, the forming position of the active layer stripe 103 to the n-InP substrate 101 is high so that an upward extending section 104a of the current blocking layer 104 can be made low. Therefore, a resistance of the clad layer 105 direct on the active layer mesa stripe 103 can be reduced. As a result, the resistance of the clad layer 105, i.e., an element resistance can be reduced without degradation of the current block function which is dependent upon the film thickness of the current blocking layer 104. The temperature increase is caused by the heat generation of the laser device itself in case of the high temperature operation or high current injecting operation but the temperature increase can be suppressed by adopting this structure. As a result, a light output characteristic can be improved.

Next, a method of manufacturing the semiconductor laser according to the first embodiment of the present invention will be described.

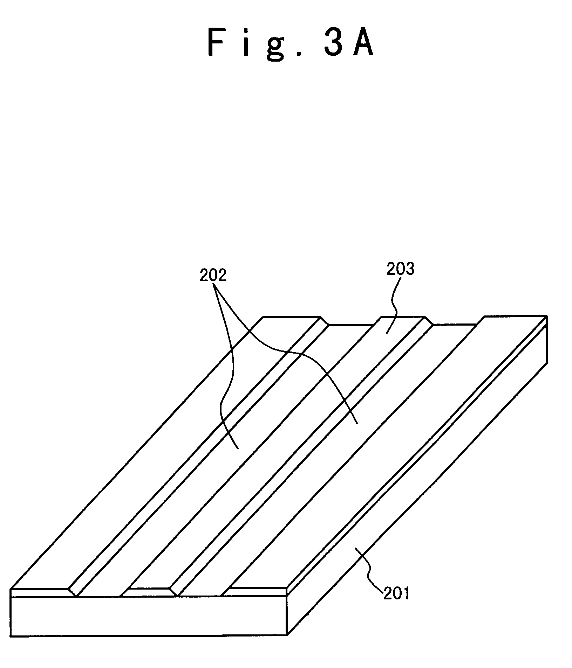

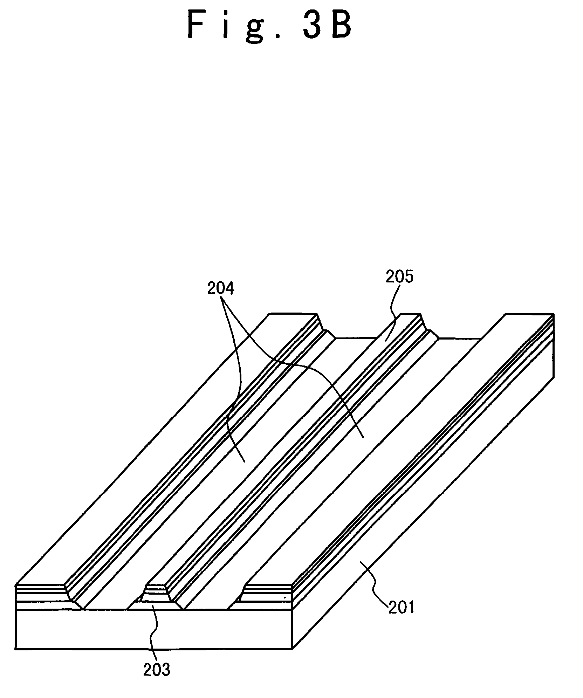

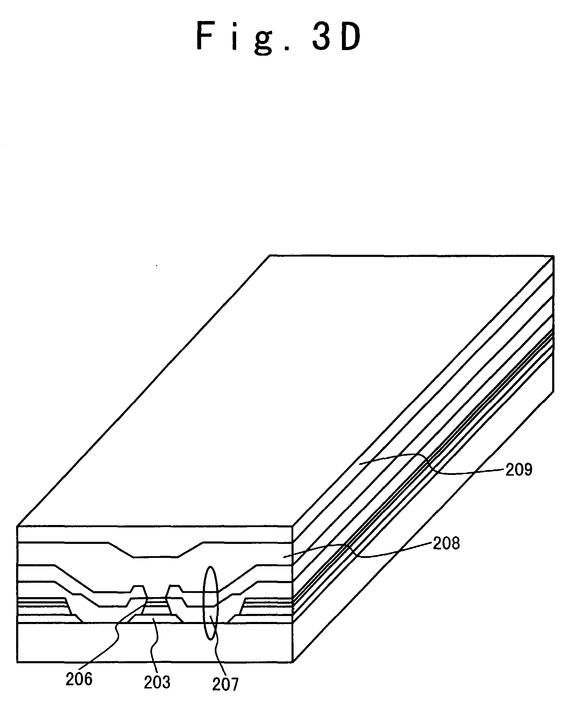

Figs. 3A to 3E show a manufacturing process in the manufacturing method of the semiconductor laser according to the first embodiment of the present invention.

First, as shown in Fig. 3A, an oxide film is deposited on an n-InP substrate 201 with (100) plane by a thermal CVD method to have the film thickness of 150 nm. Then, first selective growth masks with the opening width of 4 µm and the mask width of 2 µm are formed in a stripe shape into the direction of 〈011〉 by use of a photolithography and a wet etching. A portion shown by 202 corresponds to the mask opening. A film composed of n-InP which is the same material as the substrate 201 is formed on the first selective growth masks to have the film thickness of 0.5 µm and the carrier concentration of 1 × 10¹⁸ /cm³ using a selective MOVPE method under the condition of the grown-up pressure of 75 Torr and the grown-up temperature of 625 °C. Subsequently, the first selective growth masks are removed. Thus, the buffer layer mesa stripes 203 are formed.

Next, as shown in Fig. 3B, an oxide film is deposited by a thermal CVD method once again to have the film thickness of 150 nm. Then, second selective growth masks 204 with the opening width of 1.5 µm and the mask width of 4.5 µm are formed in a stripe shape by use of the photolithography and the wet etching method. At this time, the openings of the second selective growth masks 204 are arranged on the buffer layer mesa stripe 203. Subsequently, layers for the active layer mesa stripe 205 are formed on the buffer layer mesa stripe 203. Then, the second selective growth masks 204 are removed. Thus, the active layer mesa stripe 205 are formed.

As shown in Fig. 2, the active layer mesa stripe 205 is composed of an n-type InP layer 103a with the film thickness of 0.1 µm and the carrier concentration 5 × 10¹⁷ /cm³, an n-type InGaAsP light confining layer 103b with the band gap wavelength of 1.05 µm, the carrier concentration of 5 × 10¹⁷ /cm³ and the film thickness of 60 nm, a non-doped MQW (Multi-Quantum Well) active layer 103c with 7 periods, a non-doped InGaAsP light confining layer 103d with the film thickness of 60 nm and the band gap wavelength of 1.05 µm, and a p-type InP clad layer 103e with the film thickness of 0.1 µm and the carrier concentration of 5 × 10¹⁷ /cm³. Also, each of the 7 periods of the non-doped MQW active layer 103c has an InGaAsP well with the film thickness of 5 nm and the strain of 0.7% for the band gap wavelength 1.29 µm and a barrier layer with the film thickness of 10 nm and the band gap wavelength of 1.05 µm.

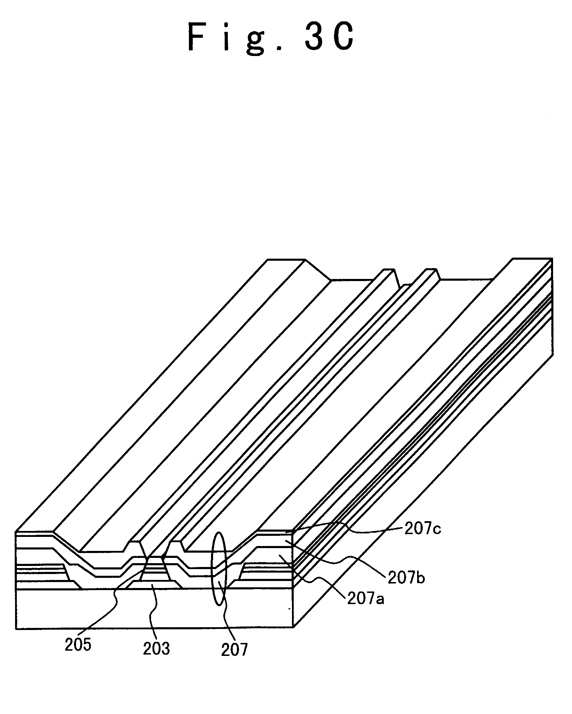

Next, as shown in Fig. 3C, an oxide film is deposited on the surface of the semiconductor wafer by the heat CVD method to have the film thickness of 350 nm. Then, oxide film masks 206 are formed on the active layer mesa stripes 205 by the photolithography and the wet etching method to the oxide film. Subsequently, using the selective MOVPE method, current blocking layers 207 are formed. The current blocking layer 207 is formed by laminating a p-type InP layer 207a with the film thickness of 0.5 µm and the carrier concentration of 5 × 10¹⁷ /cm³, an n-type InP layer 207b with the film thickness of 1.2 µm and the carrier concentration of 1 × 10¹⁸ /cm³, and a p-type InP layer 207c with the film thickness of 0.2 µm and the carrier concentration 5 × 10¹⁷ /cm³ in order, under a condition of the grown-up pressure of 75 Torr and the grown-up temperature of 625 °C.

In this case, the film thickness of the current blocking layer from the buffer layer mesa stripe is 1.4 µm. This value is smaller than 1.5 µm. However, the film thickness of the current blocking layer from the substrate is 1.9 µm (=0.5 + 1.2 + 0.2). The film thickness of the buffer layer mesa stripe is 0.5 µm. Thus, the current block layer can be formed to have a sufficient current blocking function.

Next, after the oxide film masks are removed, a clad layer 208 composed of a p-type InP layer with the film thickness of 1.5 µm and the carrier concentration 1 × 10¹⁸ /cm³ and a cap layer 209 composed of a p-type InGaAs with the film thickness of 0.2 µm and the carrier concentration 5 × 10¹⁸ /cm³ are laminated in order by a MOVPE method under a condition of the grown-up pressure of 75 Torr and the grown-up temperature of 625 °C. Then the crystal growth is completed.

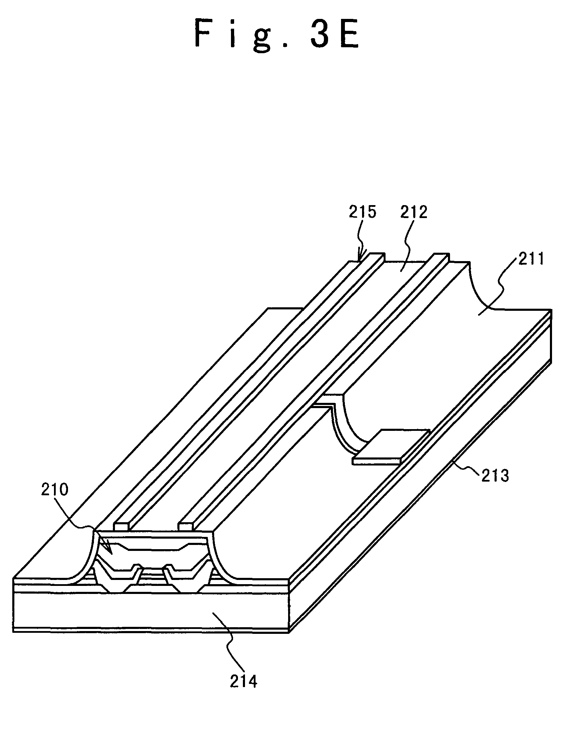

Next, a mesa stripe 210 with the width of 10 µm is formed by use of the photolithography and the wet etching method to the laminated layers such as the cap layer 209, the clad layer 208, and the current blocking layer 207. After that, an oxide film 211 is deposited to have the thickness of 350 nm, and a window for a contact is opened by use of the photolithography and the wet etching method. Ti/Au layers are deposited by a sputtering method to have the film thickness of 100/300 nm thickness, respectively. Then, an electrode 212 of the side of P is formed by use of the photolithography and the wet etching method. After this, the back surface of the semiconductor substrate 201 is polished to 90 µm, Ti/Au layers as the electrode 213 of the side of n is deposited to this back surface by the sputtering method to respectively have the film thickness of 100/300 nm. Then, a sintering process is carried out to the semiconductor substrate in the nitrogen atmosphere. Last, the semiconductor substrate is cleaved to have the device length of 300 µm and the protection films 214 with the reflectivity of 30% is formed on the surface of the end of the light output side and a high reflection films 215 with the reflectivity of 70% is formed on the surface of the opposite side. Thus, a semiconductor laser is completed as shown in Fig. 3E.

As described above, according to the semiconductor laser manufactured by the manufacturing method according to the first embodiment of the present invention, the upward extending section of the current blocking layer 207 to the active layer mesa stripe 205 can be suppressed and the resistance of the clad layer 108 direct above the active layer 206 can be reduced without degradation of the current block function.

The evaluation of the characteristic of the semiconductor laser of the present invention was carried out. As a result, the device resistance is 4 Ω, and it was confirmed that a sufficiently low value was obtained. Also, the good result was obtained in which the oscillation threshold of 8 mA and the slope efficiency of 0.50 W/A were obtained at the room temperature and the oscillation threshold of 16 mA and the slope efficiency of 0.39 W/A were obtained at 85 °C. Also, the drive current was equal to or less than 50 mA at the time of the light output of 10 mW. Also, the deviations of the threshold and slope efficiency in the identical wafer were ±0.5 mA and ±0.05 W/A, respectively, which had good uniformity not inferior to conventional examples.

### [Second embodiment]

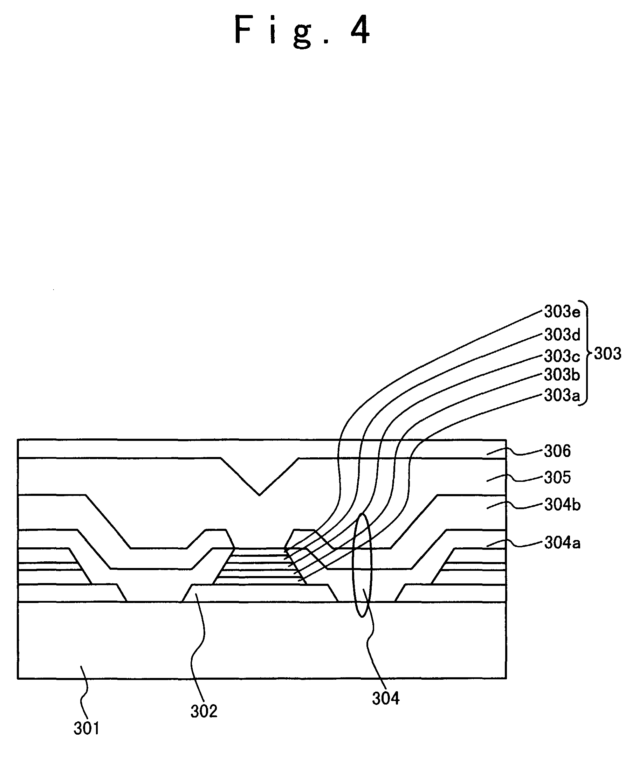

Fig. 4 shows the semiconductor laser according to the second embodiment of the present invention. This embodiment is directed to the semiconductor laser for the high output, i.e., to the high output semiconductor laser of the 1.48 - µm band for excitation of EDFA (Erbium Doped Fiber Amplifier).

Buffer layer mesa stripe 302 composed of an n-InP layer is formed on an n-InP substrate 301 with the carrier concentration of 1 × 10¹⁸ /cm³ to have the film thickness of 0.5 µm, the width of 5 µm and the carrier concentration of 1 × 10¹⁸ /cm³. The buffer layer mesa stripes 302 are formed on the substrate 301 in a predetermined interval by a selective growth method. An active layer mesa stripe 303 is provided onto the buffer layer mesa stripe 302. The active layer mesa stripe 303 is the laminate structure composed of an n-type InP clad layer 303a, a light confining layer 303b of n-type InGaAsP, a non-doped MQW layer 303c which composed of an InGaAsP well and a barrier layer, a light confining layer 303d and a p-type InP clad layer 303e. A current blocking layers 304 with the thyristor structure of pnpn-InP, i.e., composed of a pnpn layer 304a and an InP layer 304b are provided for both sides of the active layer mesa stripe 303. A clad layer 305 of p-type InP is provided onto the current blocking layer 304. Moreover, a cap layer 306 composed of p⁺-type InGaAs is provided onto the clad layer 305.

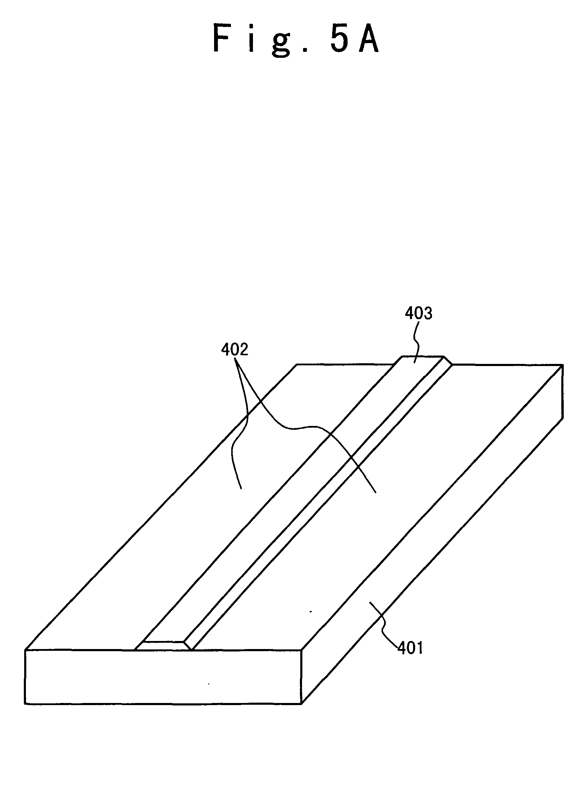

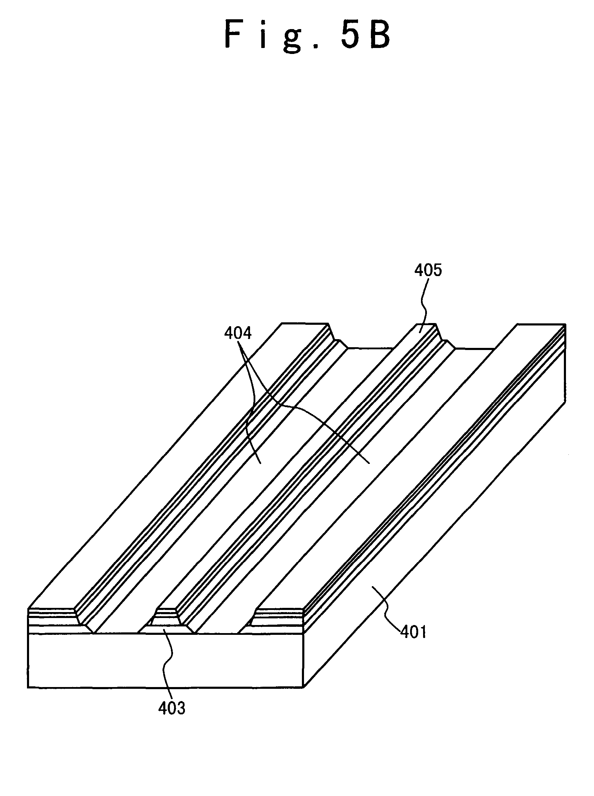

Figs. 5A to 5E show the manufacturing process of the semiconductor laser shown in Fig. 4.

First, as shown in Fig. 5A, an oxide film is deposited on a n-type InP substrate 401 having (100) plane by a thermal CVD method to have the film thickness of 150 nm. First selective growth masks 402 in a striped shape with the opening width of 4 µm are formed to the 〈011〉 direction by the photolithography and the wet etching method to the oxide film. A layer for a buffer layer mesa stripe 403 is formed by the selective MOVPE method in the condition of the grown-up pressure of 75 Torr and the grown-up temperature of 625 °C. Then, the first selective growth masks 402 is removed. Thus, the buffer layer mesa stripe 403 composed of n-type InP with the film thickness of 0.5 µm and the carrier concentration of 1 × 10¹⁸ /cm³ is formed.

Next, as shown in Fig. 5B, an oxide film is deposited once again by the thermal CVD method to have the film thickness of 150 nm. Then, second selective growth masks 404 with the opening width of 1.5 µm and the striped mask width of 5 µm are formed using the photolithography and the wet etching method to the oxide film. At this time, the opening of the second selective growth mask 404 is arranged on the buffer layer mesa stripe 403.

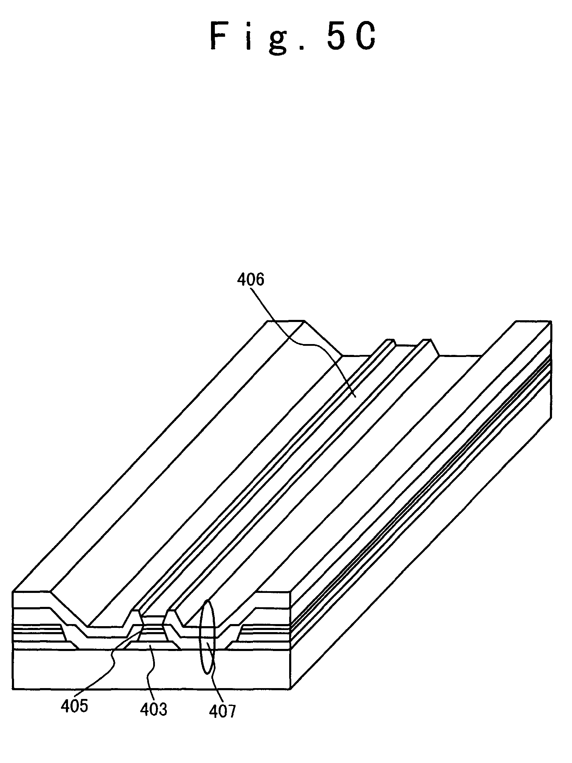

Next, as shown in Fig. 5C, the active layer mesa stripe 405 is formed. At this time, the second selective growth masks 404 are removed on the formation of the active layer mesa stripe 405. The active layer mesa stripe 405 is formed by laminating an n-InP layer 304a with the carrier concentration of 5 × 10¹⁷ /cm³ and the film thickness of 0.1 µm, a light confining layer 304b of n-type InGaAsP with the band gap wavelength of 1.13 µm, the carrier concentration of 5 × 10¹⁷ /cm³, and the film thickness of 30 nm, a non-doped MQW active layer 304c with 5 periods, each of which is composed of an InGaAsP well with the film thickness of 4 nm and the strain of 1.0% having the band gap wavelength composition of 1.45 µm and a barrier layer with the film thickness of 7 nm and the band gap wavelength of 1.2 µm, a non-doped InGaAsP light confining layer 304d with the film thickness of 30 nm and the band gap wavelength of 1.13 µm, and a p-InP clad layer 304e with the film thickness of 0.1 µm and the carrier concentration 5 × 10¹⁷ /cm³.

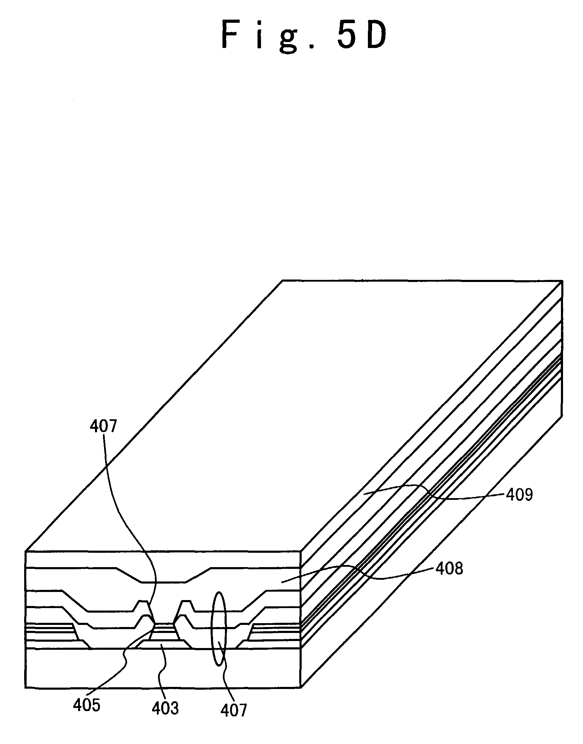

Next, an oxide film is deposited on the whole semiconductor wafer surface by the thermal CVD method to have the film thickness of 350 nm. Then, an oxide film mask 406 is formed on the active layer mesa stripe 405 by the photolithography and the wet etching method to the oxide film. Subsequently, as shown in Fig. 5D, a p-type InP layer with the film thickness of 0.5 µm and the carrier concentration of 5 × 10¹⁷ /cm³, an n-typ InP layer with the film thickness of 1.2 µm and the carrier concentration of 1 × 10¹⁷ /cm³ and a p-type InP layer with the film thickness of 0.2 µm and the carrier concentration of 5 × 10¹⁷ /cm³ are laminated in order. Thus, current blocking layers 407 are formed by the selective MOVPE in the condition of the grown-up pressure of 75 Torr and the grown-up temperature of 625 °C.

Next, the oxide film mask 406 is removed. Then, by the MOVPE method in the condition of the grown-up pressure of 75 Torr and the grown-up temperature of 625 °C, a clad layer 408 composed of a p-type InP layer with the film thickness of 1.5 µm and the carrier concentration of 1 × 10¹⁸ /cm³, and a cap layer 409 composed of p-type InGaAs with the film thickness of 0.2 µm and the carrier concentration of 5 × 10¹⁸ /cm³ are laminated in order. The crystal growth is completed as shown Fig. 5D.

Next, an oxide film 410 is deposited with the film thickness of 350 nm, and then a window for a contact is opened by the photolithography and the wet etching method to the oxide film 410. Ti/Au films are deposited by the sputtering method to have the film thicknesses of 100/300 nm, respectively. After an electrode 411 on the side of p is formed by the photolithography and the wet etching method, the semiconductor substrate is polished by 90 µm. Then, Ti/Au films are respectively deposited by the sputtering method to have the film thicknesses of 100/300 nm, for an electrode 412 on the side of n to the back surface. Subsequently, the semiconductor substrate is sintered in a nitrogen atmosphere.

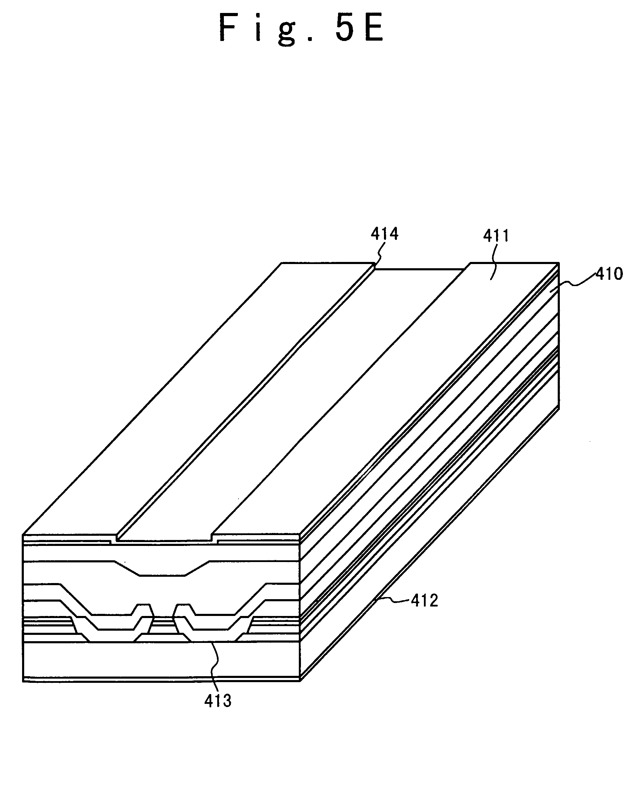

Last, the semiconductor substrate is cleaved to have the device length of 1200 µm. Also, if a low reflection film 413 with the reflectivity of 6% is formed on the surface of the end of the light output side laser and a high reflection film 414 with the reflectivity of 90% is formed on the end surface on the opposite side. Thus, the semiconductor laser is completed as shown in Fig. 5E.

According to the above second embodiment407, an upward extending section of the current blocking layer 407 to the active layer mesa stripe 403 can be suppressed low. The resistance of the active layer mesa stripe 403 direct above the clad layer 408 can be reduced and that a device is heated in high current injecting can be reduced without degradation of the current block function.

The characteristic of the semiconductor laser of the present invention was evaluated. As a result, the device resistance was 2 Ω and it was confirmed that a sufficiently low value was obtained. Also, the good result was obtained in which the oscillation threshold of 20 mA and the slope efficiency of 0.45 W/A were obtained at the room temperature, and the light output of 200 mW and the saturation output of 300 mW were obtained at the time of the drive current of 500 mA. Also, the deviations of the threshold and slope efficiency in the identical wafer were ±1 mA and ±0.05 W/A, respectively, with good uniformity.

### [Third embodiment]

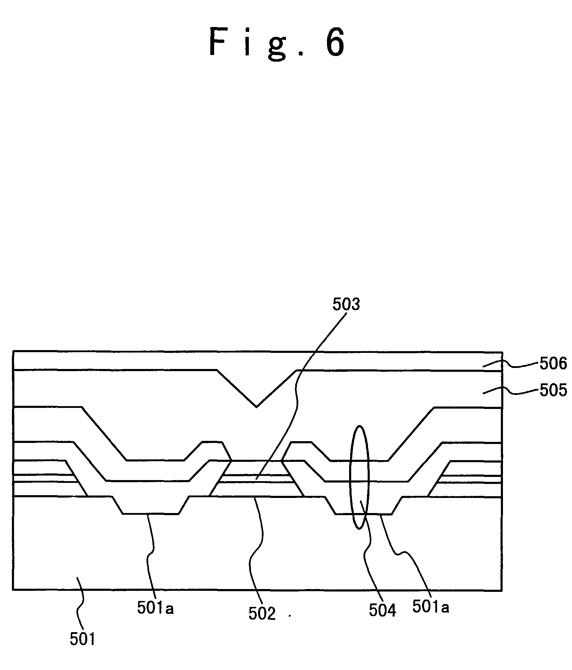

Fig. 6 shows the semiconductor laser according to the third embodiment of the present invention. In the semiconductor laser in the third embodiment, the buffer layer mesa stripe is formed by the etching method. In this example, a 1.3-µm band high temperature operation enable environment-resistant semiconductor laser for the subscriber system is used as an example.

As shown in Fig. 6, two grooves 501a with the width of 2 µm and the depth of 0.5 µm are formed in the interval of 5 µm on an n-InP semiconductor substrate 501 with the carrier concentration of 1 × 10¹⁸ /cm³ and the plane orientation of (100) using the photolithography and the wet etching method to the substrate 501. Thus, a mesa stripe 502 with the height of 0.5 µm and the width of 5 µm is formed between the grooves into the direction of 〈011〉. An active layer mesa stripe 503 is provided onto the mesa stripe 502. Also, current blocking layers 504 composed of InP and having the pnpn thyristor structure are provided for both sides of the active layer mesa stripe 503. It should be noted that mesa stripe 502 is formed into the direction of 〈011〉 by the photolithography and the wet etching method. In the manufacturing process, after the mesa stripe 502 is formed on the n-InP substrate 501, a clad layer 505 and a cap layer 506 are provided. However, the processes are the same as the manufacturing processes described in the first embodiment with reference to Figs. 3A to 3E.

### [Fourth embodiment]

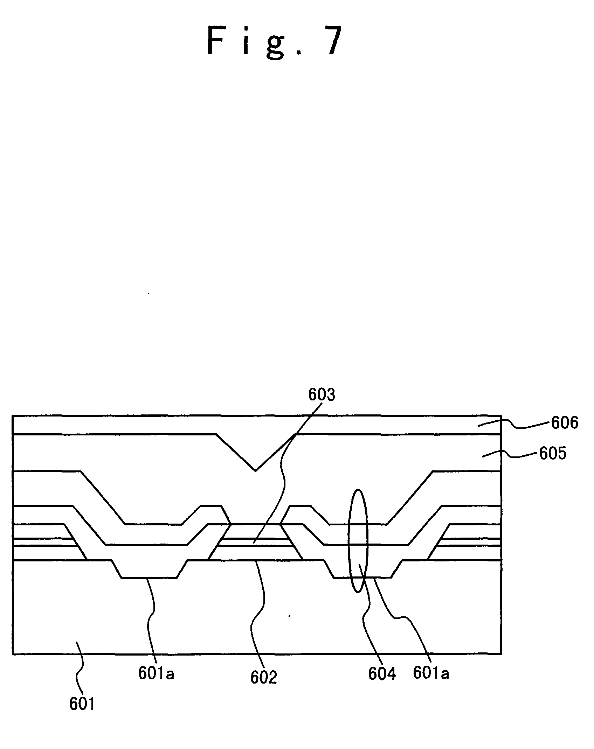

Fig. 7 shows the semiconductor laser according to the fourth embodiment of the present invention. This embodiment is an example of a 1.48-µm band high output semiconductor laser for excitation of EDFA.

As shown in Fig. 7, two grooves 601a with the width of 2 µm and the depth of 0.5 µm are formed in the interval of 5 µm on an n-InP semiconductor substrate 601 with the carrier concentration of 1 × 10¹⁸ /cm³ and the plane orientation of (100) using the photolithography and the wet etching method to the substrate 601. A mesa stripe 602 has the height of 0.5 µm and the width of 5 µm. An active layer mesa stripe 603 is provided onto the mesa stripe 602. Also, current blocking layers 604 composed of InP and having the pnpn thyristor structure is provided for both sides of the active layer mesa stripe 603. The mesa stripe 602 is formed in to the direction of 〈011〉 by the photolithography and the wet etching method to the semiconductor substrate 601. In Fig. 7, after the active layer mesa stripe 603 is formed on the mesa stripe 602, a clad layer 605 and a cap layer 606 are formed. However, the manufacturing processes are the same as those described in the second embodiment with reference to Fig. 5A to 5D.

Also, in each of the above embodiments, the InP layer of the pnpn thyristor structure is used for the current blocking layer. However, the present invention is not limited to the pnpn thyristor structure. The layer structure such as a semiinsulative InP layer having a function to block current may be used.

As described above, according to the semiconductor laser and the manufacturing method of the present invention, because the active layer mesa stripe is formed on the buffer layer mesa stripe which is formed on the semiconductor substrate, or on the mesa stripe which is formed on the surface of the semiconductor substrate, it is possible to suppress the upward extending portion of the current blocking layer to the active layer mesa stripe low, and the resistance of the clad layer directly above the active layer mesa stripe can be reduced, resulting in the semiconductor laser operable at the high light output operation and the high temperature operation can be obtained.

## Claims

1. A semiconductor laser comprising:
a semiconductor substrate (101, 201, 301, 401, 501, 601, 701) with a mesa stripe (102, 202, 302, 402, 502, 602, 702);
an active layer mesa stripe (103, 203, 303, 403, 503, 603, 703) formed on said mesa stripe;
current blocking layers (104, 204, 304, 404, 504, 604, 704) formed on said semiconductor substrate around said mesa stripe on both sides of said active layer mesa stripe; and
a clad layer (105, 205, 305, 405, 505, 605, 705) formed on said active layer mesa stripe and said current blocking layers.

2. A semiconductor laser according to claim 1, wherein said semiconductor substrate has (100) plane and said mesa stripe extends into 〈011〉 direction.

3. A semiconductor laser according to claim 1 or 2, wherein said semiconductor substrate and said mesa stripe composed of the same material and have the same carrier concentration.

4. A semiconductor laser according to any of claims 1 to 3, wherein a film thickness of said current blocking layer is smaller than (1.5 µm + (a film thickness of said mesa stripe)).

5. A semiconductor laser according to claim 4, wherein a film thickness of said current blocking layer is in a range 1.5 µm to (1.5 µm + (a film thickness of said mesa stripe)).

6. A semiconductor laser according to any of claims 1 to 5, wherein said current blocking layer has a thyristor structure of pnpn.

7. A semiconductot laser according to any of claims 1 to 6, wherein said semiconductor substrate and said mesa stripe are both an n-type, and
wherein said active layer mesa stripe 205 includes:
an n-type layer;
an n-type light confining layer;
a non-doped MQW (Multi-Quantum Well) active layer with 7 periods; and
a non-doped light confining layer,
wherein each of said 7 periods of said non-doped MQW active layer 103c has a well with a strain and a barrier layer.

8. A method of manufacturing a semiconductor laser comprising:
providing a semiconductor substrate with a mesa stripe;
forming an active layer mesa stripe on said mesa stripe;
forming current blocking layers on said semiconductor substrate around said mesa stripe on both sides of said active layer mesa stripe; and
forming a clad layer on said active layer mesa stripe and said current blocking layers.

9. A method according to claim 8, wherein said providing includes:
forming said mesa stripe on said semiconductor substrate.

10. A method according to claim 8, wherein said providing includes:
removing a portion of said semiconductor substrate forming around said mesa stripe to produce said mesa stripe.

11. A method according to any of claims 8 to 10, wherein said semiconductor substrate has (100) plane and said mesa stripe extends into 〈011〉 direction.

12. A method according to any of claims 8 to 11, wherein said semiconductor substrate and said mesa stripe composed of the same material and have the same carrier concentration.

13. A method according to any of claims 8 to 12, wherein a film thickness of said current blocking layer is smaller than (1.5 µm + (a film thickness of said mesa stripe)).

14. A method according to claim 13, wherein a film thickness of said current blocking layer is in a range 1.5 µm to (1.5 µm + (a film thickness of said mesa stripe)).

15. A method according to any of claims 8 to 14, wherein said semiconductor substrate and said mesa stripe are both an n-type, and
wherein said forming an active layer mesa stripe 205 includes:
forming an n-type layer;
forming an n-type light confining layer;
forming a non-doped MQW (Multi-Quantum Well) active layer with 7 periods, each of which has a well with a strain and a barrier layer; and
forming a non-doped light confining layer.

16. A method according to any of claims 8 to 15, wherein said forming an active layer mesa stripe includes:
forming said active layer mesa stripe by a selective MOVPE (Metal Organic Vapor Phase Epitaxy) method.
